# EUROPÄISCHE PATENTANMELDUNG

(11) **EP 4 137 613 A1**
(43) Veröffentlichungstag der Anmeldung: **22.02.2023**
(21) Anmeldenummer: 21191891.7
(22) Anmeldetag: 18.08.2021
(51) Int. Cl.: C30B 15/20, C30B 15/30, C30B 29/06

(54) **VERFAHREN ZUR HERSTELLUNG EINER EPITAKTISCH BESCHICHTETEN HABLEITERSCHEIBE AUS EINKRISTALLINEM SILIZIUM**

(71) Anmelder: Siltronic AG, 81677 München (DE)
(72) Erfinder: Mangelberger, Karl, 5122 Ach (AT); Heuwieser, Walter, 84533 Stammham (DE)
(74) Vertreter: Staudacher, Wolfgang

(57) **Zusammenfassung**

Verfahren zur Herstellung einer epitaktisch beschichteten Hableiterscheibe aus einkristallinem Silizium, umfassend:
das Bereitstellen einer Schmelze aus Silizium in einem Tiegel;
das Ziehen eines Einkristalls aus Silizium von einer Oberfläche der Schmelze mit einer Ziehgeschwindigkeit v gemäß der CZ-Methode, wobei Sauerstoff und Bor in den Einkristall eingebaut werden und die Konzentration von Sauerstoff im Einkristall nicht weniger als 6,4 × 10¹⁷ Atome/cm³ und nicht mehr als 8,0 × 10¹⁷ Atome/cm³ beträgt und die Resistivität des Einkristalls nicht weniger als 10 mΩcm und nicht mehr als 25 mΩcm ist, und wobei auf ein Dotieren der Schmelze mit Stickstoff und/oder Kohlenstoff verzichtet wird;
das Anlegen eines CUSP-Magnetfelds an die Schmelze während des Ziehens des Einkristalls aus Silizium, der von einem Hitzeschild umgeben ist;
die Regelung der Ziehgeschwindigkeit v und eines axialen Temperaturgradienten G an der Phasengrenze zwischen dem Einkristall und der Schmelze derart, dass der Quotient v/G nicht weniger als 0,13 mm²/°C min und nicht mehr als 0,20 mm²/°C min ist;
das Erhitzen des Einkristalls mittels eines ringförmigen Heizers, der über der Schmelze angeordnet ist und den Einkristall umgibt;
das Herstellen einer Substratscheibe aus einkristallinem Silizium mit einer polierten Seitenfläche durch Bearbeiten des Einkristalls aus Silizium; und
das Abscheiden einer epitaktischen Schicht aus Silizium auf der polierten Seitenfläche der Substratscheibe, wobei das Abscheiden der epitaktischen Schicht die erste Wärmebehandlung ist, im Verlauf derer die Substratscheibe auf eine Temperatur von nicht weniger als 700 °C erhitzt wird.

## Beschreibung

Gegenstand der Erfindung ist ein Verfahren zur Herstellung einer epitaktisch beschichteten Hableiterscheibe aus einkristallinem Silizium, die insbesondere zur Weiterverarbeitung zu elektronischen Bauelementen wie CMOS Bildsensoren (CMOS image sensors, CIS) geeignet ist.

Stand der Technik / Probleme Um für die genannte Anwendung geeignet zu sein, dürfen metallische Verunreinigungen nicht zu den elektronischen Strukturen gelangen, die in der epitaktischen Schicht untergebracht sind.

In US 2014/0374861 A1 ist beschrieben, dass die Gegenwart von Sauerstoffpräzipitaten, sogenannten BMDs (bulk micro defects) in der Substratscheibe, auf der die epitaktische Schicht abgeschieden ist, typische Bauelement-Defekte unterdrückt, die auf eine Kontamination mit metallischen Verunreinigungen zurückzuführen sind, sofern die Konzentration von BMDs mindestens 1,0 × 10⁹ / cm³ beträgt.

Um eine solche, vergleichsweise hohe Konzentration an BMDs bereitstellen zu können, wird häufig vorgeschlagen, den Einkristall, der die Substratscheibe liefert, mit Stickstoff oder Kohlenstoff zu dotieren und/oder die Substratscheibe vor dem Abscheiden der epitaktischen Schicht einer Wärmebehandlung zu unterziehen, die Keime stabilisiert, aus denen später BMDs entstehen können.

Wegen des Dotierens mit Stickstoff oder Kohlenstoff können jedoch auch Oberflächen-Defekte in der epitaktischen Schicht entstehen, und die Wärmebehandlung der Substratscheibe stellt einen zusätzlichen Verfahrensschritt dar, der die Herstellungskosten erhöht.

In der DE 10 2014 221 421 B3 ist ein Verfahren beschrieben, das ohne das Dotieren mit Stickstoff und ohne eine Wärmebehandlung vor dem Abscheiden der epitaktischen Schicht auskommt. Nachteilig an diesem Verfahren ist jedoch, dass die geforderte BMD-Dichte von mindestens 1,0 × 10⁹ / cm³ nicht erreicht wird und nicht gleichmäßig verteilt ist, sondern zum Rand der Halbleiterscheibe mit epitaktischer Schicht hin deutlich abfällt.

Es ist die Aufgabe der vorliegenden Erfindung, ein solches Verfahren anzubieten, das eine Halbleiterscheibe mit epitaktischer Schicht liefert, in der eine BMD-Dichte erzeugt werden kann, die mindestens 1,0 × 10⁹ / cm³ erreicht und zwar auch in deren Randbereich.

Die Aufgabe der Erfindung wird gelöst durch ein Verfahren zur Herstellung einer epitaktisch beschichteten Hableiterscheibe aus einkristallinem Silizium, umfassend:
das Bereitstellen einer Schmelze aus Silizium in einem Tiegel;
das Ziehen eines Einkristalls aus Silizium von einer Oberfläche der Schmelze mit einer Ziehgeschwindigkeit v gemäß der CZ-Methode, wobei Sauerstoff und Bor in den Einkristall eingebaut werden und die Konzentration von Sauerstoff im Einkristall nicht weniger als 6,4 × 10¹⁷ Atome/cm³ und nicht mehr als 8,0 × 10¹⁷ Atome/cm³ beträgt und die Resistivität des Einkristalls nicht weniger als 10 mΩcm und nicht mehr als 25 mΩcm ist, und wobei auf ein Dotieren der Schmelze mit Stickstoff und/oder Kohlenstoff verzichtet wird;
das Anlegen eines CUSP-Magnetfelds an die Schmelze während des Ziehens des Einkristalls aus Silizium, der von einem Hitzeschild umgeben ist;
die Regelung der Ziehgeschwindigkeit v und eines axialen Temperaturgradienten G an der Phasengrenze zwischen dem Einkristall und der Schmelze derart, dass der Quotient v/G nicht weniger als 0,13 mm²/°C min und nicht mehr als 0,20 mm²/°C min ist;
das Erhitzen des Einkristalls mittels eines ringförmigen Heizers, der über der Schmelze angeordnet ist und den Einkristall umgibt;
das Herstellen einer Substratscheibe aus einkristallinem Silizium mit einer polierten Seitenfläche durch Bearbeiten des Einkristalls aus Silizium; und
das Abscheiden einer epitaktischen Schicht aus Silizium auf der polierten Seitenfläche der Substratscheibe, wobei das Abscheiden der epitaktischen Schicht die erste Wärmebehandlung ist, im Verlauf derer die Substratscheibe auf eine Temperatur von nicht weniger als 700 °C erhitzt wird.

Eine mit diesem Verfahren hergestellte epitaktisch beschichtete Halbleiterscheibe aus einkristallinem Silizium, die p/p+ dotiert ist, eignet sich besonders für die Herstellung von CIS-Bauelementen, insbesondere wegen der radial homogenen BMD-Verteilung, die mittels einer Wärmebehandlung unter der epitaktischen Schicht erzeugt werden kann. Die Wärmebehandlung umfasst vorzugsweise das Erhitzen der epitaktisch beschichteten Halbleiterscheibe zunächst auf eine Temperatur von 780 °C über einen Zeitraum von 3 h und anschließend auf eine Temperatur von 1000 °C über einen Zeitraum von 16 h. Ersatzweise kann auch eine Wärmebehandlung mit vergleichbarem thermischen Budget im Zuge der Weiterverarbeitung der epitaktisch beschichteten Halbleiterscheibe zu elektronischen Bauelementen durchgeführt werden.

Die Herstellung des Einkristalls, von dem die Substratscheibe abgetrennt wird, die im Verlauf des Verfahrens epitaktisch beschichtet wird, erfolgt gemäß der MCZ-Methode, wonach der Einkristall an einem Keimkristall aus einer Schmelze gezogen wird, die in einem Tiegel erzeugt und mit einem Magnetfeld beaufschlagt wird. Als Magnetfeld wird ein axialsymmetrisches Magnetfeld, ein CUSP-Magnetfeld, angewendet. Das CUSP-Magnetfeld erreicht eine maximale Feldstärke von vorzugsweise nicht weniger als 105 mT und nicht mehr als 116 mT, wobei die Ebene des CUSP-Magnetfelds mit einer Feldstärke von 0 mT vorzugsweise nicht weniger als 30 mm und nicht mehr als 80 mm, besonders bevorzugt 50 mm unter der Oberfläche der Schmelze liegt.

Der Einkristall wird vorzugweise aktiv gekühlt. Die Abkühlrate im Temperaturbereich von 1000 °C bis 800 °C beträgt vorzugsweise nicht weniger als 0,7 °C/min und nicht mehr als 1 °C/min.

Der Abstand eines unteren Rands des Hitzeschilds zur Oberfläche der Schmelze beträgt vorzugsweise nicht weniger als 35 mm und nicht mehr als 45 mm.

Die Menge an Sauerstoff, die beim Ziehen des Einkristalls in den Einkristall gelangt, wird durch das Einstellen von Prozessparametern kontrolliert. Zu diesen Prozessparametern gehören insbesondere die Stärke des CUSP-Magnetfelds, die Geschwindigkeit der Drehung des Tiegels sowie der Druck des Spülgases, das über die Schmelze geleitet wird, um aus der Schmelze entweichendes Siliziumoxid aus der Umgebung des Einkristalls zu entfernen. Die Geschwindigkeit der Drehung des Tiegels beträgt vorzugsweise nicht weniger als 3,5 U/min und nicht mehr als 6,0 U/min. Der Druck des Spülgases, beispielsweise von Argon, Wasserstoff oder einer Mischung der beiden Gase, beträgt vorzugsweise nicht weniger als 2500 Pa und nicht mehr als 8500 Pa.

Die Punktdefektverteilung im Einkristall hat einen besonderen Einfluss darauf, dass sich später BMDs in der epitaktisch beschichteten Halbleiterscheibe bilden können. Bekanntermaßen ist die Punktdefektverteilung davon abhängig, welchen Wert der Quotient v/G während des Ziehens des Einkristall hatte. Es kommt demnach auf das Verhältnis von Ziehgeschwindigkeit v und dem axialen Temperaturgradienten G and der Phasengrenze zwischen dem wachsenden Einkristall und der Schmelze an. Das erfindungsgemäße Verfahren verlangt einen Quotienten v/G von nicht weniger als 0,13 mm²/°C min und nicht mehr als 0,20 mm²/°C min. Die Ziehgeschwindigkeit beträgt vorzugsweise nicht weniger als 0,4 mm/min und nicht mehr als 0,48 mm/min.

Der axiale Temperaturgradient G wird im Randbereich des wachsenden Einkristalls zusätzlich beeinflusst durch das Erhitzen des Einkristalls mittels eines ringförmigen Heizers, der über der Schmelze angeordnet ist und den Einkristall umgibt. Für einen Einkristall mit einem Durchmesser von 300 mm beträgt die Leistung des ringförmigen Heizers vorzugsweise nicht weniger als 7 kW und nicht mehr als 13 kW.

Der gezogene Einkristall hat einen Durchmesser von vorzugsweise mindestens 200 mm, besonders bevorzugt mindestens 300 mm, und wird zu Substratscheiben aus einkristallinem Silizium verarbeitet. Die Arbeitsschritte umfassen neben dem Teilen des Einkristalls in Scheiben weitere mechanische Bearbeitungsschritte wie das Läppen und/oder das Schleifen der Seitenflächen der Scheiben und das Verrunden der Kanten der Scheiben. Die Substratscheiben werden vorzugsweise auch chemisch geätzt und insbesondere chemisch-mechanisch poliert. Eine Substratscheibe weist daher eine polierte Kante und mindestens eine polierte Seitenfläche auf. Vorzugsweise umfassen die Polierschritte das gleichzeitige Polieren (DSP) der Vorder- und Rückseite der Substratscheibe und das Polieren (CMP) der Vorderseite der Substratscheibe.

Die epitaktische Schicht aus Silizium wird vorzugsweise auf der polierten Vorderseite der Substratscheibe abgeschieden. Dieser Schritt wird vorzugsweise in einem Einzelscheibenreaktor durchgeführt, beispielsweise in einem von Applied Materials angebotenen Reaktor vom Typ Centura^{®}. Das Abscheidegas enthält vorzugsweise ein Wasserstoff enthaltendes Silan, beispielsweise Trichlorsilan (TCS). Die Abscheidetemperatur liegt bei Verwendung von TCS in einem Temperaturbereich von vorzugsweise nicht weniger als 1000 °C und nicht mehr als 1250 °C. Die Dicke der epitaktischen Schicht beträgt vorzugsweise mindestens 1 µm. Das Abscheiden der epitaktischen Schicht ist die erste Wärmebehandlung, im Verlauf derer die Substratscheibe auf eine Temperatur von nicht weniger als 700 °C erhitzt wird. Es findet vor dem Abscheiden der epitaktischen Schicht also keine Wärmebehandlung zur Nukleation von BMD-Keimen statt. Die Substratscheibe ist auch nicht absichtlich mit Stickstoff und/oder Kohlenstoff dotiert.

Die so hergestellte epitaktisch beschichtete Hableiterscheibe aus einkristallinem Silizium hat im Bereich der Substratscheibe die Konzentration an interstitiellem Sauerstoff und die Resistivität des Einkristalls, von dem die Substratscheibe stammt. Die Konzentration an Sauerstoff beträgt demnach nicht weniger als 6,4 × 10¹⁷ Atome/cm³ und nicht mehr als 8,0 × 10¹⁷ Atome/cm³ (gemäß dem Standard new ASTM) und die Resistivität beträgt nicht weniger als 10 mΩcm und nicht mehr als 25 mΩcm.

Wird die epitaktisch beschichtete Hableiterscheibe aus einkristallinem Silizium einer Standard-Wärmebehandlung unterzogen, die das Erhitzen auf eine Temperatur von 780 °C über einen Zeitraum von 3 h und anschließend auf eine Temperatur von 1000 °C über einen Zeitraum von 16 h umfasst, oder einer Wärmebehandlung mit vergleichbarem thermischen Budget, werden unterhalb der epitaktischen Schicht BMDs mit einer Dichte von mindestens 1 × 10⁹ / cm³ gebildet, die radial homogen verteilt sind. Die Änderung der BMD-Dichte über den Radius ist kleiner als 170%, berechnet gemäß der Formel ((BMDmax-BMDmin) / BMDmean) × 100%, wobei BMDmax, BMDmin und BMDmean die gemessene größte, kleinste und mittlere BMD-Dichte bezeichnen.

Die Erfindung wird nachfolgend unter Bezugnahme zu Zeichnungen weiter beschrieben.

### Kurzbeschreibung der Figuren

Fig. 1 zeigt Merkmale einer Vorrichtung, die geeignet ist, um das erfindungsgemäße Verfahren auszuführen.
Fig. 2 zeigt die gemittelten BMD-Dichten von erfindungsgemäß hergestellten, epitaktisch beschichteten Halbleiterscheiben nach einer Standard-Wärmebehandlung in Abhängigkeit der relativen axialen Position (raP) der entsprechenden Substratscheiben im Einkristall.
**Fig. 3** zeigt die gemittelten BMD-Dichten von fünf erfindungsgemäß hergestellten, epitaktisch beschichteten Halbleiterscheiben in Abhängigkeit von der radialen Position (Pos), an der die BMD-Dichten gemessen wurden.

### Liste der verwendeten Bezugszeichen

- **1**: Einkristall
- **2**: Hitzeschild
- **3**: Schmelze
- **4**: ringförmiger Heizer
- **5**: Einrichtung zum Kühlen des Einkristalls
- **6**: Tiegel
- **7**: Stütztiegel
- **8**: Welle
- **9**: Widerstandsheizung
- **10**: Einrichtung zum Erzeugen eines CUSP-Magnetfelds

### Detaillierte Beschreibung erfindungsgemäßer Ausführungsbeispiele

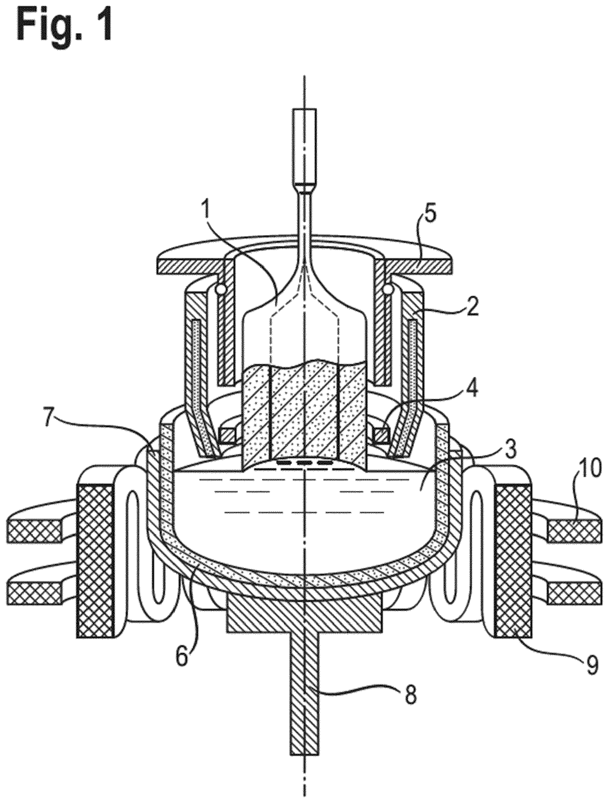

Fig.1 zeigt die schematische Darstellung der näheren Umgebung (hot zone) des Einkristalls während dessen Herstellung bei Verwendung einer Vorrichtung, die zur Durchführung des erfindungsgemäßen Verfahrens geeignet ist. Der wachsende Einkristall 1 ist von einem Hitzeschild 2 umgeben, dessen unteres Ende einen geringen Abstand zur Schmelze 3 hat. Weiterhin ist im Bereich des unteren Endes des Hitzeschilds 2 ein ringförmiger Heizer 4 vorhanden, durch den Wärme zum Rand der Phasengrenze zwischen dem Einkristall 1 und der Schmelze 3 zugeführt wird. Der ringförmige Heizer 4 unterstützt die Regelung des Temperaturgradienten am Rand der Phasengrenze zwischen dem wachsenden Einkristall 1 und der Schmelze 3 und ist vorzugsweise auch Bestandteil einer Regelung des Durchmessers des Einkristalls. Auf Höhe des mittleren und oberen Bereichs des Hitzeschilds 2 und mit einigem Abstand zum ringförmigen Heizer 4 umgibt den Einkristall 1 auch eine Einrichtung 5 zum Kühlen des Einkristalls, vorzugsweise ein mit Wasser gekühlter Kühler. Die Schmelze 3 befindet sich in einem Tiegel 6 aus Quarz, der wiederum von einem Stütztiegel 7 aus Graphit gehalten wird. Die Tiegel 6,7 und die Schmelze 3 ruhen auf einem Ende einer dreh-, heb- und senkbaren Welle 8. Der Schmelze 3 wird hauptsächlich Wärme über eine Widerstandsheizung 9 zugeführt, die um den Stütztiegel 7 herum angeordnet ist. Eine Einrichtung 10 zum Erzeugen des CUSP-Magnetfelds, das an die Schmelze 3 angelegt wird, umgibt wiederum die Widerstandsheizung 9.

Es wurden mehrere Einkristalle aus Silizium in einer Vorrichtung mit den in Fig.1 dargestellten Merkmalen auf erfindungsgemäße Weise gezogen und zu epitaktisch beschichteten Halbleiterscheiben mit einem Durchmesser von 300 mm weiterverarbeitet.

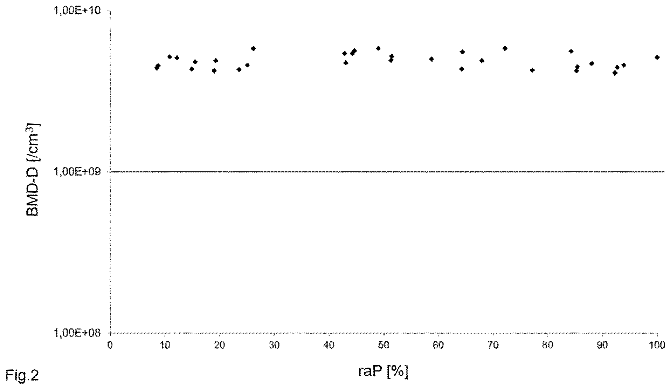

Fig. 2 zeigt die gemittelten BMD-Dichten (BMD-D) von diesen Halbleiterscheiben nach einer Standard-Wärmebehandlung in Abhängigkeit der relativen axialen Position (raP) der entsprechenden Substratscheiben im Einkristall.

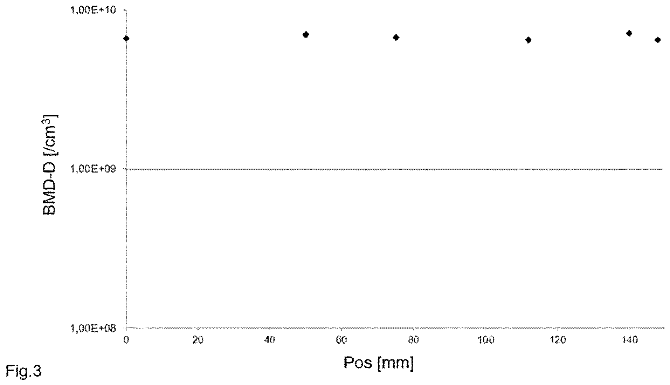

Fig. 3 zeigt die gemittelten BMD-Dichten (BMD-D) von fünf der erfindungsgemäß hergestellten, epitaktisch beschichteten Halbleiterscheiben in Abhängigkeit von der radialen Position (Pos), an der die BMD-Dichten gemessen wurden.

## Patentansprüche

1. Verfahren zur Herstellung einer epitaktisch beschichteten Hableiterscheibe aus einkristallinem Silizium, umfassend:
das Bereitstellen einer Schmelze aus Silizium in einem Tiegel;
das Ziehen eines Einkristalls aus Silizium von einer Oberfläche der Schmelze mit einer Ziehgeschwindigkeit v gemäß der CZ-Methode, wobei Sauerstoff und Bor in den Einkristall eingebaut werden und die Konzentration von Sauerstoff im Einkristall nicht weniger als 6,4 × 10¹⁷ Atome/cm³ und nicht mehr als 8,0 × 10¹⁷ Atome/cm³ beträgt und die Resistivität des Einkristalls nicht weniger als 10 mΩcm und nicht mehr als 25 mΩcm ist, und wobei auf ein Dotieren der Schmelze mit Stickstoff und/oder Kohlenstoff verzichtet wird;
das Anlegen eines CUSP-Magnetfelds an die Schmelze während des Ziehens des Einkristalls aus Silizium, der von einem Hitzeschild umgeben ist;
die Regelung der Ziehgeschwindigkeit v und eines axialen Temperaturgradienten G an der Phasengrenze zwischen dem Einkristall und der Schmelze derart, dass der Quotient v/G nicht weniger als 0,13 mm²/°C min und nicht mehr als 0,20 mm²/°C min ist;
das Erhitzen des Einkristalls mittels eines ringförmigen Heizers, der über der Schmelze angeordnet ist und den Einkristall umgibt;
das Herstellen einer Substratscheibe aus einkristallinem Silizium mit einer polierten Seitenfläche durch Bearbeiten des Einkristalls aus Silizium; und
das Abscheiden einer epitaktischen Schicht aus Silizium auf der polierten Seitenfläche der Substratscheibe, wobei das Abscheiden der epitaktischen Schicht die erste Wärmebehandlung ist, im Verlauf derer die Substratscheibe auf eine Temperatur von nicht weniger als 700 °C erhitzt wird.

2. Verfahren nach Anspruch 1, **gekennzeichnet durch** das Kühlen des aus der Schmelze gezogenen Einkristalls mit einer Abkühlrate, die in einem Temperaturbereich von 1000 °C bis 800 °C nicht weniger als 0,7 °C/min und nicht mehr als 1 °C/min beträgt.

3. Verfahren nach Anspruch 1 oder Anspruch 2, **dadurch gekennzeichnet, dass** der Abstand eines unteren Rands des Hitzeschilds zur Oberfläche der Schmelze nicht weniger als 35 mm und nicht mehr als 45 mm beträgt.

4. Verfahren nach einem der Ansprüche 1 bis 3, **dadurch gekennzeichnet, dass** das CUSP-Magnetfeld eine maximale Feldstärke von nicht weniger als 105 mT und nicht mehr als 116 mT erreicht, und die Ebene des CUSP-Magnetfelds mit einer Feldstärke von 0 mT nicht weniger als 30 mm und nicht mehr als 80 mm unter der Oberfläche der Schmelze liegt.

5. Verfahren nach einem der Ansprüche 1 bis 4, **gekennzeichnet durch** das Drehen des Tiegels mit einer Geschwindigkeit von nicht weniger als 3,5 U/min und nicht mehr als 6,0 U/min.

6. Verfahren nach einem der Ansprüche 1 bis 5, **gekennzeichnet durch** das Ziehen des Einkristalls in einer Atmosphäre aus Spülgas, deren Druck nicht weniger als 2500 Pa und nicht mehr als 8500 Pa beträgt.

7. Verfahren nach einem der Ansprüche 1 bis 6, **dadurch gekennzeichnet, dass** der Einkristall einen Durchmesser von 300 mm hat, und die Leistung des ringförmigen Heizers nicht weniger als 7 kW und nicht mehr als 13 kW beträgt.
